# EUROPEAN PATENT APPLICATION

(11) **EP 1 674 592 A2**
(43) Date of publication of application: **28.06.2006**
(21) Application number: 05077982.6
(22) Date of filing: 22.12.2005
(51) Int. Cl.: C23C 16/455

(54) **Thin film processing system with different processing chambers**

(30) Priority: 22.12.2004 JP 2004370813
(71) Applicant: Canon Anelva Corporation, Fuchushi, Tokyo 183-8508 (JP)
(72) Inventor: Sakai, Junro, Tokyo (JP)
(74) Representative: Winckels, Johannes Hubertus F.

(57) **Abstract**

A thin film processing system (10) alternately introducing two types of material gases into a reaction vessel unit so as to process the surface of a substrate, provided with a reaction vessel (10A) (first chamber) formed inside the reaction vessel unit and into which a first material gas is introduced, a reaction vessel (second chamber) formed inside the reaction vessel (10B) unit stacked over this and into which a second material gas is introduced, an opening formed in a wall between the two adjoining reaction vessels, a plurality of partition plates (12,13) moving back and forth between the two reaction vessels in a coordinated manner, one of which designed to close the opening and at least one of which carrying a substrate, and a material gas feed mechanism (24) and exhaust mechanism for supplying the first material gas and second material gas to the substrate parallel to the substrate surface in the two vessels.

## Description

### BACKGROUND OF THE INVENTION

### 1. Field of the Invention

The present invention relates to a thin film processing system, more particularly relates to a thin film processing system suitable for deposition, etching, etc. of thin film utilized in the production of semiconductor devices, display devices, storage devices, etc.

### 2. Description of the Related Art

In the production of semiconductor devices of integrated circuits, in the past, thin films of metals, metal oxides, metal nitrides, etc. have been used for transistors, capacitors, interlayer connections, electrode interconnects, etc. These thin films have been produced in the past using sputtering systems, evaporation systems, and chemical vapor deposition (CVD) systems. The sputtering method has problems in the ability of the thin films to cover the surfaces of substrates with step differences. Therefore, in recent years, the chemical vapor deposition method has been utilized to improve the step coverage.

In the general chemical vapor deposition method, a substrate is placed on a substrate holder placed in a reaction vessel, the substrate is heated to the required temperature, and material is introduced into the reaction vessel in the gaseous state so as to grow the required thin film on the substrate surface by a heat reaction. As one example, an example of growing a thin film of titanium nitride (hereinafter referred to as "TiN") will be explained. As the Ti material gas, to obtain the vapor pressure, an organic material gas containing Ti, for example, tetradiethylamino titanium (hereinafter referred to as "TDEAT") is used, while as the nitrogen material gas, for example ammonia gas (hereinafter referred to as "NH₃") is used. The reaction vessel is evacuated by a vacuum pump to 1 Pa or less, then the TDEAT and NH₃ are introduced from piping to the inside of the reaction vessel. The TDEAT and NH₃ react on the surface of the heated substrate to form a TiN thin film. Since the thin film is grown by the heat reaction on the substrate surface, even if the substrate has step differences, a thin film can be formed following the shape of the surface and consequently the step coverage becomes good.

However, if the TDEAT and NH₃ contact each other at other locations inside the reaction vessel, they end up reacting and TiN is formed at locations other than the substrate surface. There was the problem that this dropped onto the substrate surface as foreign matter. In addition, when the step differences of the substrate are narrow in opening and deep, the TDEAT and NH₃ end up reacting at the entrances to these grooves or holes. The growth of the thin film at the entrances makes it impossible for the materials to reach deep into the grooves or holes. It was therefore learned that there were limits to the step coverage by this. This problem is described in, for example, Ryoo Tobe et al., *Semiconductor and Integrated Circuit 56th Symposium Papers,* The Electrochemical Society of Japan, Electronic Materials Committee, Osaka, 1999, p. 77-82.

The above facts regarding the problems show that systems based on the conventional chemical vapor deposition method have limits when producing semiconductor devices where microprocessing is required. In actuality, when using the chemical vapor deposition method to grow a TiN film on, for example, a substrate having holes of opening diameters of 0.18 µm and depths of 0.6 µm, the film deposits thickly at the top parts of the holes, but the material fails to reach down to the bottoms of the holes, so the phenomenon was observed of the thicknesses of the side walls ending up becoming smaller the further down to the bottoms of the holes.

At the present time, attempts are being made to improve on this detrimental aspect of the conventional chemical vapor deposition method. Suntola et al. proposed and realized an atomic layer epitaxy method where, for example, when growing a thin film of an AₓB_{y} compound comprised of two types of elements A and B, two types of material gases including the elements A or B are alternately introduced into the reaction vessel so as to cause one material gas adsorbed on the substrate surface to react with the next fed other material gas and thereby grow one atomic layer at a time. In principle, the ability to grow one atomic layer at a time enables the thickness of growth to be controlled to the smallest unit in the thickness direction of the thin film, that is, the individual atomic layer, and enables the growth of thin film of a uniform thickness in the plane of the substrate surface. If considering this technique in its broader implications, since two types of material gases are not introduced simultaneously, it is possible to suppress the reaction between the material gases in the spaces in the reaction vessel and at the entrances of fine grooves and holes and thereby promote only reaction at the substrate surface. As a result, this promises the growth of thin films with good step coverage.

However, the above method of alternately introducing the material gases A and B into a single reaction vessel has the following defect: When introducing the next material gas, it becomes necessary to exhaust the material gas introduced before this and remaining inside the reaction vessel from the reaction vessel by a purge gas. As a result, the time for supplying the purge gas for exhausting the previous gas becomes long. This purging is performed as many as two times per cycle. Therefore, compared with the general vapor deposition method, there was the defect that the productivity remarkably declined.

Further, as another known document disclosing the atomic layer epitaxy system, there is Japanese Patent Publication (A) No. 5-234899. Further, as general prior art of atomic layer epitaxy, Japanese Patent No. 2828152 may be mentioned. In particular, the atomic layer epitaxy system disclosed in Japanese Patent Publication (A) No. 5-234899 is configured to alternately emit a plurality of types of material gases from a plurality of gas cells and is configured to make a plurality of substrates rotate in the perpendicular direction with respect to gas diffusion plates provided at the plurality of gas cells so as to repeatedly perform atomic layer epitaxy on the substrates. The material gases are supplied to flow in a direction vertical to the substrates. Further, the system of Japanese Patent Publication (A) No. 5-234899 is a rotary type complicated in configuration.

When growing a thin film of an AₓB_{y} compound comprised of two types of elements A and B, if using the atomic layer growth system alternately introducing two types of material gas including the elements A or B into the reaction vessel so as to cause one material gas adsorbed on the substrate surface to react with the next fed other material gas and thereby grow one atomic layer at a time, since two types of material gases are not introduced simultaneously, it is possible to suppress the reaction between the material gases in the spaces in the reaction vessel and at the entrances of fine grooves and holes and thereby promote only reaction at the substrate surface. As a result, this promises the growth of thin films with good step coverage.

However, in this atomic layer growth system, even if a thin film with a good step coverage can be grown, to grow one atomic layer, it is necessary to supply one material gas (A), supply purge gas to purge the remaining material gas, supply the other material gas (B), and supply purge gas to purge the remaining material gas, so there was the problem that an extremely long time was required.

Further, the system disclosed in Japanese Patent Publication (A) No. 5-234899 is a rotary type which is complicated in structure.

### SUMMARY OF THE INVENTION

An object of the present invention, in consideration of the above problems, is to provide a thin film processing system having a simple structure, able to shorten the time for growing one atomic layer even if using a growth method alternately supplying materials for growing a thin film with a good step coverage, and able to form a uniform film over the entire substrate.

The thin film processing system according to the present invention is configured as follows in order to achieve the above object.

The thin film processing system according to the present invention is a thin film processing system alternately introducing at least two types of material gases into a reaction vessel unit so as to process the surface of a substrate, provided with a first chamber (reaction vessel 10A) formed inside the reaction vessel unit and into which a first material gas (material gas A) is introduced, a second chamber (reaction vessel 10B) formed inside the reaction vessel unit stacked over the first chamber and into which a second material gas (material gas B) is introduced, an opening formed in a wall between the adjoining first chamber and second chamber, a plurality of partition plates moving back and forth between the first and second chambers in a coordinated manner, one of which designed to close the opening and at least one of which carrying a substrate, and a material gas feed mechanism and exhaust mechanism for supplying the first material gas and second material gas to the substrate parallel to the substrate surface in each of the first chamber and second chamber.

Specifically, in the above-mentioned configuration, there is provided a system for alternately introducing at least two types of material gases (A and B) into a reaction vessel unit to process a substrate surface, comprising a reaction vessel for introducing a material gas A and a reaction vessel for introducing a material gas B stacked together and having a plurality of partition plates moving back and forth between the two reaction vessels in a coordinated manner. The lower partition plate carries the substrate to be processed. Since first and second chambers of the reaction vessel unit constituted by the two reaction vessels are configured to enable different material gases to be supplied so as to independently form films by atomic layer epitaxy etc., the growth time can be shortened. Further, since the flow of each material gas with respect to the substrate in each chamber is made the horizontal direction parallel to the surface of the substrate, the entire substrate surface can be formed with a uniform film.

In the above-mentioned thin film processing system, preferably each of the first chamber and second chamber is provided with a purge gas feed mechanism, and the fed purge gas is made to flow parallel to the substrate surface by an exhaust operation of the exhaust mechanism. By making the purge gas flow parallel to the substrate surface, remaining unnecessary material gas can be efficiently exhausted to the outside.

In the above-mentioned thin film processing system, preferably an elevator mechanism for making the plurality of partition plates simultaneously move is provided. By making the plurality of partition plates move as one unit simultaneously in the vertical direction, any of the plurality of partition plates can be used as a means for quickly closing the opening, the chambers used as the reaction vessels can be easily and quickly switched, and the switching can be realized by a simple configuration.

In the above-mentioned thin film processing system, preferably a chamber provided at the bottommost level is provided with a plurality of pins, the bottommost partition plate has a plurality of holes through which the pins can pass, and a substrate is placed on the pins by the descent of the partition plates. According to this configuration, in the case of a substrate processing system, it is possible to suppress disturbance of the gas in the reaction vessel and prevent an uncontrolled increase in the substrate holder heat capacity or thickness.

In the above-mentioned thin film processing system, preferably the system has two adjoining chambers and is provided with heating devices for heating the partition plate carrying the substrate by heat radiation at the bottom side of the lower chamber and the top side of the upper chamber. According to this configuration, it becomes possible to set different substrate temperatures for each of the alternately supplied material gases.

Specifically, according to the present invention, that is, there is provided a system alternately introducing at least two types of material gases into a reaction vessel unit so as to process a substrate surface, structured comprised of a reaction vessel into which a first gas is introduced and a reaction vessel into which a second gas is introduced stacked together so as to form an overall reaction vessel, an opening passing through a wall forming a boundary between the same, and a plurality of partition plates which move in a coordinated manner back and forth between the two reaction vessels so that the opening is closed by one of the plurality of partition plates, another of the partition plates carrying the substrate. Therefore, by alternately supplying material gases and supplying purge gas between the two, it is possible to make the film growth time extremely short and improve the productivity. Further, by supplying the material gases etc. so as to flow parallel to the substrate surface, it is possible to form a uniform film over the entire substrate surface. Further, the system as a whole can be realized by a simple structure and therefore is practical.

Further, according to the present invention, in the first and second chambers corresponding to the two reaction vessels stacked adjoining each other, the wall forming the boundary between the two chambers is formed with an opening for transfer of the substrate being processed, the opening is closed by any one of the plurality of partition plates, another partition plate is used as a substrate holder, and an elevator mechanism for moving the plurality of partition plates in the vertical direction is provided so as to enable the individual chambers to be utilized as reaction vessels with a good timing and simultaneously to transfer the substrate between the reaction vessels in a short time by a simple configuration.

Further, according to the present invention, by providing a reaction vessel chamber positioned at the bottommost level with a plurality of pins and providing the bottommost partition plate with a plurality of holes through which the pins can pass, lowering the partition plate will result in the substrate being placed on the pins, so in addition to the above-mentioned effects, it is possible to suppress disturbance of the gas in the reaction vessel and prevent an uncontrolled increase in the substrate holder heat capacity or thickness. Further, the system is provided with two independent systems of heating devices for heating the partition plate carrying the substrate by heat radiation at the bottom side of the lower reaction vessel and the top side of the upper reaction vessel. Accordingly, it becomes possible to set different substrate temperatures for each of the alternately supplied material gases.

### BRIEF DESCRIPTION OF THE DRAWINGS

These and other objects and features of the present invention will become clearer from the following description of the preferred embodiments given with reference to the attached drawings, wherein:
FIG. 1 is a longitudinal sectional view of a thin film processing system according to a first embodiment of the present invention;
FIG. 2 is a view of the operating state of partition plates of a thin film processing system according to the first embodiment;
FIGS. 3A to 3C are timing charts showing the relationship between the growth time and gas flow rate in a thin film processing system according to a first embodiment;
FIG. 4 is a longitudinal sectional view for explaining the configuration of a substrate carrying mechanism of a thin film processing system according to a first embodiment; and
FIG. 5 is a longitudinal sectional view of a thin film processing system according to a second embodiment of the present invention.

### DESCRIPTION OF THE PREFERRED EMBODIMENTS

Below, preferred embodiments of the present invention will be explained with reference to the attached drawings.

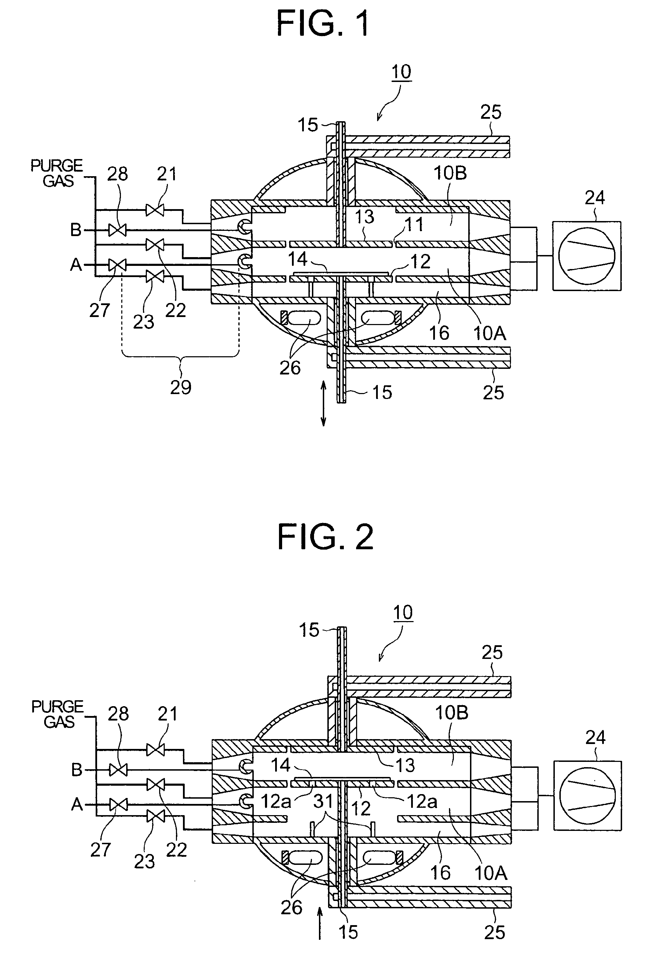

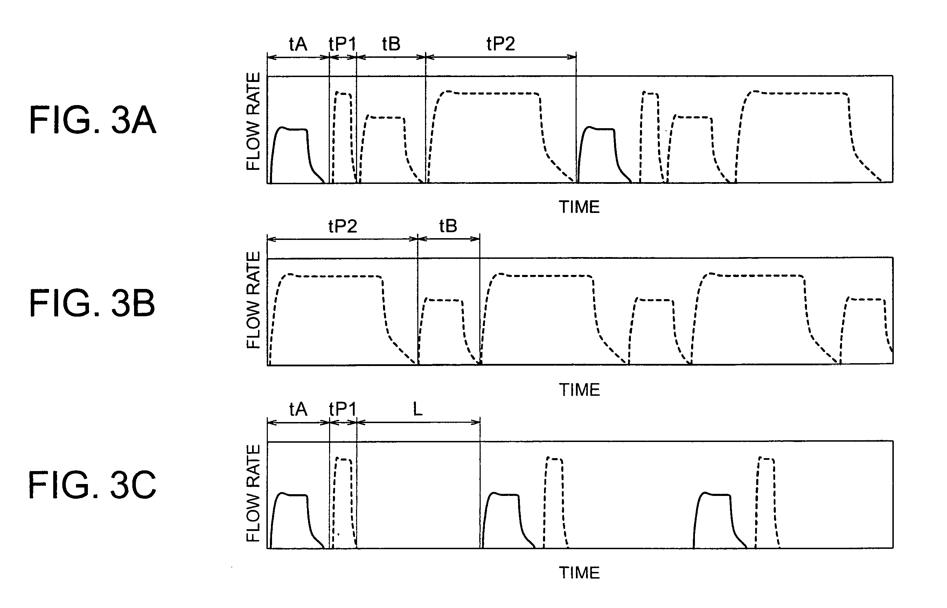

Referring to FIG. 1 to FIGS. 3A, 3B and 3C, first, a thin film processing system according to a first embodiment of the present invention will be explained. The thin film processing system of the first embodiment is comprised of a reaction vessel unit of a vertical two-stage stacked structure, a substrate mounter, and an elevator. The thin film processing system 10 is a system which alternately introduces at least two types of material gases (for example A, B, etc.) into the reaction vessel unit to process the surface of the substrate. The reaction vessel unit of this thin film processing system 10 is structured comprised of a reaction vessel (first chamber) 10A into which a material gas A is introduced and a reaction vessel (second chamber) 10B into which a material gas B is introduced stacked together. The wall at the part where the reaction vessel 10A and the reaction vessel 10B adjoin each other is formed with an opening 11 leading to the spaces inside the two reaction vessels. The opening 11 is closed for example by either of the two partition plates 12 and 13 by having the two partition plates 12 and 13 move back and forth between the reaction vessel 10A and the reaction vessel 10B. The partition plate 12 among the two partition plates 12 and 13 also functions as a substrate holder.

A substrate 14 conveyed by a robot conveyance system (not shown), as shown in FIG. 1, is transferred onto the partition plate constituting the substrate holder 12 by an elevation operation of an elevator mechanism 15.

The reaction vessel 10A, reaction vessel 10B, and bottom vessel 16 are supplied with a purge gas constituted by a gas not reacting with the material gas such as N₂, Ar, He, etc. to an extent of several hundred SCCM to several tens of SLM by opening the gas valves 21, 22, and 23. This gas is exhausted using a vacuum pump 24 through the reaction vessel 10A, reaction vessel 10B, and bottom vessel 16.

The substrate 14 and substrate holder 2 are heated to a required temperature by heating lamps 26 placed at the bottom.

The purge gas is controlled in flow rate by a not shown flow rate control system. The introduction of the purge gas is reduced or the gas valve 22 is closed to stop the flow, then the material gas A is supplied for the required time by opening the gas valve 27 so as to cause the material gas A or an intermediate product derived from the material gas A to be adsorbed on the substrate 14. After this, the feed of the material gas A is stopped by closing the valve 27.

Next, the gas valve 22 is opened to again supply the purge gas and simultaneously the substrate holder 12 is moved by the elevator mechanism 15 to the position shown in FIG. 2. At the reaction vessel 10B, at the same time as the movement of the substrate holder 12, the valve 21 is closed to stop the supply of the purge gas, then the valve 28 is opened to introduce the material gas B to the reaction vessel 10B. The material gas A or intermediate product derived from the material gas A adsorbed on the substrate 14 reacts with the material gas B whereby an AₓB_{y} compound is grown on the substrate 14. After enough time has passed for the reaction, the valve 28 is closed.

In the reaction vessel 10A, the material gas A adsorbed at locations other than the substrate 14 or otherwise remaining is exhausted together with the purge gas. After enough time has passed for the material gas A to be exhausted, the flow rate of the purge gas is lowered using a not shown flow rate control system or the gas valve 22 is closed to stop the supply.

Next, the substrate holder 12 and partition plate 13 linked with the same are moved using the elevator mechanism 15 to the position shown in FIG. 1.

The switching operations of the above-mentioned gas valves 21 to 23, 27, and 28, the operation of the elevator mechanism 15, and the operations of the exhaust vacuum pump 24, not shown flow rate control system, etc. are controlled by a not shown control system.

By repeating the above procedure as a cycle, the substrate 14 is successively grown with thin films comprised of an AxBy compound. The thin film of the material formed by the material gas A adsorbed on the substrate 14 has coverage sufficient to cover the substrate surface. Further, if the material formed by the material gas B reacts with the material (A) on the substrate 14 by a stoichiometric ratio, growth of one atomic layer in one cycle becomes possible.

Next, referring to FIGS. 3A to 3C, the elapse of time in the processings at the thin film processing system 10 according to the first embodiment will be explained. In FIGS. 3A to 3C, the abscissa indicates the growth time, while the ordinate indicates the flow rate of the material gas etc. In particular, the material gas A is shown by the solid lines, the purge gas by the broken lines, and the material gas B by the dotted lines. As shown in FIGS. 3A, 3B and 3C, the time during which the material gas A is supplied is indicated by "tA", the time during which purge gas is supplied for purging the remaining material gas A is indicated by "tP1", the time during which the material gas B is supplied is indicated by "tB", and the time during which purge gas is supplied for purging the remaining material gas B is indicated by "tP2". Note that FIG. 3A shows the elapse of the processing time by a conventional system configured so as to alternately introduce the material gases A and B into a single reaction vessel, FIG. 3B shows the elapse of the processing time at the reaction vessel B in the first embodiment, and FIG. 3C shows the elapse of the processing time at the reaction vessel A in the first embodiment.

As shown in FIG. 3C, in the reaction vessel 10A, the time "tA" during which the material gas A is supplied and the purge time "tP1" are necessary. On the other hand, similarly as shown in FIG. 3B, in the reaction vessel 10B, the time "tB" during which the material gas B is supplied and the purge time "tP2" are required. In the example shown in FIG. 3, since the purge time "tP2" is the longest, the time required for one cycle is mainly determined based on the total of "tB" and "tP2". If considering the fact that the thickness of the film grown in one cycle is at most one atomic layer, the growth time "tG" for obtaining the thickness of n number of atomic layers can be expressed by tG=nx(tB+tP2) =nx(tA+tP1+L). Here, "L" is the time during which no gas is supplied in the reaction vessel A.

As opposed to this, with the conventional vapor growth method designed to alternately supply the material gas A and the material gas B to the same reaction vessel, as shown in FIG. 3A, the growth time becomes tG=nx(tA+tP1+tB+tP2) and the time of the total of all gas introduction times becomes necessary.

Formation of an actual TiN thin film requires a time "tA" during which the TDMAT (corresponding to the material gas A) is supplied of 2 seconds, a time "tP1" during which the TDMAT is purged of 5 seconds, a time "tB" during which NH₃ (corresponding to material gas B) is supplied of 3 seconds, and a time "tP2" during which NH₃ is purged of 11 seconds. With the conventional growth method alternately introducing material gases etc. into the same reaction vessel, one cycle took 21 seconds, while with the processing method based on the thin film processing system according to the first embodiment, one cycle took 14 seconds, i.e., the time for each cycle could be shortened. This means that the productivity can be improved 1.5-fold.

Further, according to the first embodiment, the substrate 14 processed in the reaction vessel 10A is immediately transferred by the elevator mechanism 15 to the reaction vessel 10B, so even if the purging of the reaction vessel 10A by the purge gas is insufficient, there are the advantages that effect of the remaining material gas A on the substrate 14 can be reduced and the time of the most time-consuming purging process can be shortened.

Further, in the configuration of the system of the first embodiment, as shown in FIG. 1, since the substrate 14 is immediately transferred by the elevator mechanism 15 to the other reaction vessel, even if a small amount of material gas remains in the introduction piping 29, it can be sufficiently exhausted while the substrate 14 is being next processed. Further, since the material gas piping is separately provided for each reaction vessel, mixing of material gases and contamination can also be avoided.

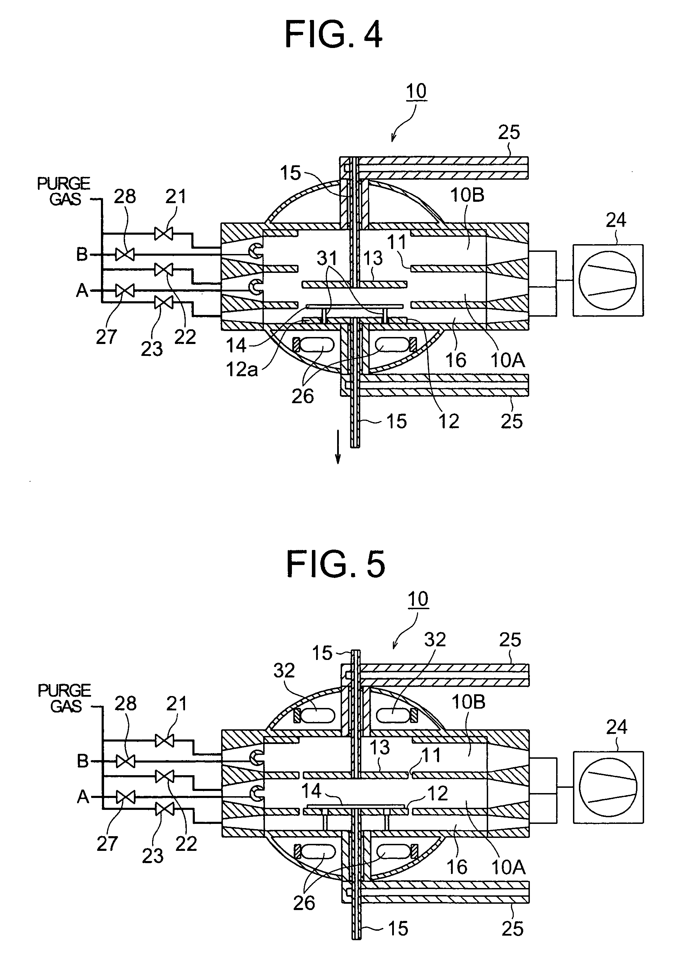

Next, referring to FIG. 4, the configuration and action of the substrate carrying mechanism in the thin film processing system according to the first embodiment will be explained. In FIG. 4, parts substantially the same as parts explained in FIG. 1 etc. are assigned the same reference notations and overlapping detailed explanations are omitted.

In the above thin film processing system 10, the bottom vessel 16 of the reaction vessel unit placed at the bottommost level is provided with a plurality of pins 31, while the bottommost partition plate, that is, the substrate holder 12, is formed with a plurality of holes 12a through which the above-mentioned pins can pass. By the substrate holder 12 descending as shown in FIG. 4, the substrate 14 is placed on the pins 31.

The partition plate placed at the bottommost level, that is, the substrate holder 12, is formed with holes 12a through which the pins 31 provided at the bottom vessel 16 can pass. When introducing the substrate 14 into the reaction vessel 10A, the substrate holder 12 is lowered down to the position of the bottom vessel 16 by the elevator mechanism 15. At this time, the pins 31 pass through the holes 12a of the substrate holder 12 and stick out above the substrate holder 12. In this state, a substrate 14 conveyed by a not shown robot conveyance system into the reaction vessel 10A can be placed on the pins 31 by the elevation operation of the robot conveyance system.

After this, if the substrate holder 12 is moved by driving the elevator mechanism 15 to the same position as the bottom floor of the reaction vessel 10A, the preparations for the growth process are completed. Further, when recovering the substrate 14, it is possible to perform a procedure opposite to the above.

By providing the bottom vessel 16 and providing this with the pins 31, there is substantially no disturbance of the flows of the gases at the reaction vessel 10A and reaction vessel 10B, while by attaching a conveyance system at the substrate holder 12, greater complexity of the structure and increase in thickness of the substrate holder 12 can be avoided. If the thickness of the substrate holder 12 increases, when placing the substrate holder 12 at the same position as the bottom surface of the reaction vessels 10A and 10B, the flow of gas has to be prevented from becoming disturbed by equivalently increasing the thickness of the bottom surface of the reaction vessel unit. There may be the defects of an increase in the heat capacity or unintentional enlargement of the system due to this, but these can be avoided in the first embodiment.

By using the substrate conveyance system of the thus configured thin film processing system 10, it becomes possible to convey a substrate without disturbing the flows of gases in the reaction vessels 10A and 10B by the simple configuration of providing the bottom vessel 16 with pins 31 and providing the substrate holder 12 with holes 12a through which the pins 31 can pass.

Next, referring to FIG. 5, a thin film processing system according to a second embodiment of the present invention will be explained. In FIG. 5, parts substantially the same as the parts explained in FIG. 1 etc. are assigned the same reference notations and overlapping detailed explanations are omitted.

The above-mentioned thin film processing system 10 has two adjoining reaction vessels 10A and 10B and is provided with two independent sets of heating lamps 26 and 32 for heating by heat radiation the substrate holder (partition plate) 12 carrying the substrate 14 at the bottom side of the lower reaction vessel 10A and the top side of the upper reaction vessel 10B.

As the material of the lower partition plate, that is, the substrate holder 12, for example Si, SiC, graphite , AlN, metal, or another good heat absorbing material opaque to the wavelength of the light radiated from the heating lamps 26 and 32 is used. On the other hand, as the material of the upper partition plate 13, upper wall of the reaction vessel 10B, and lower wall of the bottom vessel 16, a good heat conducting material opaque to the wavelength of the light radiated from the heating lamp 26 is used. As this material, for example, there are SiO₂, sapphire, etc. The substrate holder 12 is heated by the heat from the upper lamps 32 conducted through the upper wall of the reaction vessel 10B and the upper partition plate 13 and by the heat from the lower lamps 26 conducted through the lower wall of the bottom vessel 16.

When introducing the material gas A, that is, the TDEAT, into the reaction vessel 10A and making it be adsorbed on the substrate 14, the outputs of the lamps 26 and 32are lowered to set the temperature of the substrate holder 12 to become for example 220°C. When moving the substrate holder 12 to the reaction vessel 10B and supplying the material gas B, that is, NH₃, the outputs of the lamps 26 and 32 are increased to raise the temperature of the substrate holder 12 to 280°C. When introducing the TDEAT, the probability of adsorption at a relatively low substrate temperature is raised, while when introducing NH3, it is possible to set a relatively high substrate temperature for promoting the reaction between the TDEAT or its intermediate product adsorbed on the substrate 14 with the NH₃.

By using the thin film processing system 10 according to the above embodiments, it is possible to quickly change the substrate temperature even with repeated relatively short time processing introducing the material gas and purge gas for periods of several seconds to several tens of seconds at a time and possible to select the substrate temperature optimal for a plurality of different materials.

As opposed to this, in the conventional system, the substrate holder becomes large in heat capacity or the partition plates become large in heat absorption and the substrate holder can only be heated from one side, so it was impossible to freely and quickly change the substrate temperature in the middle of the short-time processing alternately supplying different gases.

In the above embodiments, the TDEAT and NH₃ were used to form a TiN thin film, but if growing the film like in the past by fixing the substrate holder to a temperature of 250°C, poor quality thin film with residual unreacted NH₃ or tetrafluoromethane is formed among the TiN thin films. As opposed to this, in the present embodiment, as explained above, it becomes possible to heat the substrate to a relatively high temperature only when supplying NH₃, so the effect of reduction of the remaining unreacted gas is large.

Note that in the thin film processing system according to the present invention, it is clear, even without giving any examples, that in addition to what is shown in the above embodiment, similar effects can be obtained by a TaN or other conductive thin film, an Al₂O₃, PbZrTiO, or other dielectric thin film, or a GaAs, InP, or other semiconductor thin film.

The configurations, shapes, sizes (thicknesses), and layouts explained in the above embodiments are only shown schematically to an extent enabling the present invention to be understood and worked. Further, the numerical values and compositions (materials) are only shown for illustration. Therefore, the present invention is not limited to the explained embodiments and can be changed in various ways within the scope of the technical idea shown in the claims.

The present invention contains subject matter related to Japanese Patent Application No. 2004-370813 filed in the Japan Patent Office on December 22, 2004, the entire contents of which being incorporated herein by reference.

## Claims

1. A thin film processing system alternately introducing at least two types of material gases into a reaction vessel unit so as to process the surface of a substrate, provided with:
a first chamber formed inside said reaction vessel unit and into which a first material gas is introduced,
a second chamber formed inside said reaction vessel unit stacked over said first chamber and into which a second material gas is introduced,
an opening formed in a wall between the adjoining first chamber and second chamber,
a plurality of partition plates moving back and forth between said first and second chambers in a coordinated manner, one of which designed to close said opening and at least one of which carrying said substrate, and
a material gas feed mechanism and exhaust mechanism for supplying said first material gas and second material gas to said substrate parallel to the substrate surface in each of said first chamber and second chamber.

2. A thin film processing system as set forth in claim 1, wherein each of said first chamber and second chamber is provided with a purge gas feed mechanism, and the fed purge gas is made to flow parallel to the substrate surface by an exhaust operation of the exhaust mechanism.

3. A thin film processing system as set forth in claim 1, further provided with an elevator mechanism for making the plurality of partition plates simultaneously move.

4. A thin film processing system is set forth in claim 1, wherein a chamber positioned at the bottommost level is provided with a plurality of pins, the bottommost partition plate has a plurality of holes through which the pins can pass, and a substrate is placed on the pins by the descent of said partition plate.

5. A thin film processing system as set forth in claim 1, having two adjoining chambers and provided with heating devices for heating a partition plate carrying a substrate by heat radiation at the bottom side of the lower chamber and the top side of the upper chamber.
